# EUROPEAN PATENT APPLICATION

(11) **EP 1 289 021 A1**
(43) Date of publication of application: **05.03.2003**
(21) Application number: 01810833.2
(22) Date of filing: 28.08.2001
(51) Int. Cl.: H01L 27/16, H01L 35/00

(54) **Auxiliary power supply device for a semiconductor switch device**

(71) Applicant: ABB RESEARCH LTD., 8050 Zürich (CH)
(72) Inventor: Celanovic, Nikola, 5405 baden-Dättwil (CH); Grbo, Zeljiko, 21000 Novi Sad (YU); Jörg, Pieder, 7013 Domat/Ems (CH)
(74) Representative: ABB Patent Attorneys

(57) **Abstract**

The invention refers to an auxiliary power supply device (10) for a semiconductor switch device (11), a module comprising an auxiliary power supply device (10) and a semiconductor switch device (11), a semiconductor switch device (11) and a method for supplying auxiliary power to a semiconductor switch device (11). Said auxiliary power supply device (10) comprises at least one thermoelectric generator (2), which supplies an auxiliary voltage (Vₐ).

## Description

### Field of the Invention

The invention relates to an auxiliary power supply device for a semiconductor switch device, to a module comprising an auxiliary power supply device and a semiconductor switch device to a semiconductor switch device and to a method for supplying auxiliary power to a semiconductor switch device according to the definition of the claims.

### Background of the Invention

Semiconductor switch devices conduct and interrupt the flow of electric current in electric conductors in a controlled manner. Semiconductor switch devices are pursued in an thyristor structure, like Gate Turn-Off (GTO) thyristors, MOS-Controlled Thyristors (MCT), MOS Turn-Off thyristors (MTO), Insulated Gate Thyristors (IGT), Integrated Gate-Commutated Thyristors (IGCT), etc. and/or in an transistor structure, like bipolar transistors, MOS Field-Effect Transistor (MOSFET), Insulated Gate Bipolar Transistors (IGBT), etc.. Many applications of semiconductor switch devices are possible. For example, semiconductor switch devices make electric voltage source converters (VSC) possible. VSC are used in applications such as electric drives and converters in high voltage direct current (HVDC) transmission systems.

Semiconductor switch devices require auxiliary power supply devices for a reliable control and/or protection. From the standpoint of an efficient system design, particularly for medium and high electric voltage applications of semiconductor switch devices, it is an aim to supply the auxiliary power directly from a main voltage of the semiconductor switch device.

Up to this date, to the best of our knowledge the auxiliary power supply for a semiconductor switch device suffers from major limitations.

Due to large improvements in the overall system design, considerable efforts are expended to design auxiliary power supply devices powered directly from the main voltage. In a classical approach, a power electronics solution is realized, using at least one step down converter to step down electric voltage from a main voltage of e.g. several kV to an auxiliary voltage of e.g. +/-3 to +/-20V.

Particularly critical is in the start-up mode of operation, where the semiconductor switch device needs to start working by itself from a link voltage, which is not well defined (particularly in transients).

Critical is also the very large electric voltage transfer ratio (factor 10² to 10⁵), requiring a very low duty cycle of the step down converter and a large turn ratio of a transformer. The solution of this problem consists in providing multiple stages of step down converters coupled to semiconductor switch devices. High voltage switching occurs always using this classical power electronics approach.

### Summary of the invention

It is, therefore, an object of the present invention to provide an auxiliary power supply device for a semiconductor switch device, which is improved with respect to the classic power electronics approach. In particular, the auxiliary power supply device, shall be cost-effective, respectively shall have a simple construction and respectively shall avoid electric isolation stages.

An additional object of the present invention is to provide an improved method for supplying auxiliary power to a semiconductor switch device, which is easy to apply and reliable.

A further object of the present invention is to provide an auxiliary power supply device, which is compatible with known and proven standards and techniques in the industry, especially with the electric power transmission and distribution industry.

To this end, the present invention provides an auxiliary power supply device for a semiconductor switch device, a module comprising an auxiliary power supply device and a semiconductor switch device, a semiconductor switch device and a method for supplying auxiliary power to a semiconductor switch device according to the definition of the claims.

The present invention proposes an auxiliary power supply device for a semiconductor switch device, a module comprising an auxiliary power supply device and a semiconductor switch device, a semiconductor switch device and a method for supplying auxiliary power to a semiconductor switch device, which is based on the thermoelectric conversion principle. The thermoelectric principle is known for quite some time now. In 1823 Seebeck noticed an electric current flowing through two dissimilar electric conductors when one of them is heated. Some 12 years later Peltier noticed a temperature change in the vicinity of the junction of two dissimilar electric conductors when an electric current is passed through them.

Today, the thermoelectric principle is predominantly used for space applications. In fact all the nuclear power sources flown by the United States until 1993 and reportedly all but two of the former Soviet Union achieved their power conversion through the use of thermoelectric generators (TEG). A TEG converts heat into electricity and are very simple, extremely reliable and electrically insulated.

A TEG also has various terrestrial applications. Perhaps the most important applications are in the cathodic protection of gas pipelines. Additional applications can be found in power supplies for telecommunication equipment, large geothermal power plants, gas powered electricity sources, some small battery operated refrigeration equipment, sensors and so on. The thermoelectric power generation principle is perhaps best suited for applications where its relatively low efficiency is outweighed by the free (often waste) energy, or the particular convenience. For example, US 4,651,019 teaches a TEG system with a thermopile producing DC electric energy by using electric energy as primary power source and a fossil fuel burner as secondary power source, when the primary power source fails.

Surprisingly, it was found, that the thermoelectric conversion principle allows providing an auxiliary power supply device for a semiconductor switch device, in that at least one TEG supplies an auxiliary voltage. Moreover, it was found by surprise, that the thermoelectric conversion principle allows packaging of an auxiliary power supply device and a semiconductor switch device to form a module. Finally, it was found, that this method is surprisingly easy to realize and highly reliable.

Generally speaking, the semiconductor switch device opens and/or closes a flow of electric current in an electric conductor. Preferably, the semiconductor switch device switches an electric voltage or main voltage. Using the thermoelectric energy conversion principle, heat generated within the semiconductor switch device is converted to an auxiliary voltage simply by applying at least one heat generator and/or at least one heat sink to the TEG. Preferably, the TEG is "sandwiched" between a heat generator on one side and a heat sink on the other. The heat generator and the TEG are joint, such that a heat flows from the heat generator to the TEG. The TEG and the heat sink are joint, such that a heat flows from the TEG to the heat sink. The heat generator is the "hot" side of the auxiliary power supply device, the heat sink is the "cold" side of the auxiliary power supply device. Preferably, the TEG has a sufficiently high temperature gradient between its "hot" and "cold" side for producing an auxiliary voltage.

The TEG is embedded in a thermo-management of the semiconductor switch device. Thermo-management means, that the temperature gradient of the TEG is produced actively and/or passively. Preferably, and by means of an active thermo-management, the heat generator is at least one electric resistor and/or at least one positive temperature coefficient (PTC) resistor. Preferably, the heat generator is waste energy conducted to the TEG by means of a passive thermo-management relying on at least one thermo-conductor. Preferably, the heat sink is a heat sink of the semiconductor switch device, such as a water-cooled respectively air-cooled heat sink.

In the case of HVDC applications, where a semiconductor switch device comprises a multitude of switches, preferably a multitude of TEG is provided, each TEG is applied to a heat sink of a switch.

This novel use of the thermoelectric principle to provide the auxiliary power supply device from heat generated within the semiconductor switch device solves most of the limitations of the above described power electronics approach:
- The auxiliary power supply device is electrically insulated, requiring no high voltage switches and no transformers.
- For HVDC applications, the electric insulation of the semiconductor switch device requires much attention and high efforts. The invention allows the use of waste heat from the voltage balancing resistor network to power a TEG, without affecting the electric insulation.
- The auxiliary power supply device requires minimal additional control electronics, because it starts up automatically as a PTC resistor heats up, and because it is extremely reliable.
- In addition, due to the relatively small size of the TEG and due to the fact that often semiconductor materials are used in the TEG, packaging of the TEG into a module, together with the semiconductor switch device is very likely.
- Finally, due to the constant temperature of a heat generator, thermal cycling of the semiconductor switch device can be reduced by keeping a constant temperature within the entire module as long as the main power supply is present.

### Brief Description of the Drawings

Preferred embodiments of the invention are illustrated by means of Figs. 1 to 3:
- Fig. 1: is a schematic representation of a portion of an auxiliary power supply device for a semiconductor switch device,
- Fig. 2: is a block diagram of an auxiliary power supply device for a semiconductor switch device, and
- Fig. 3: is a schematic representation of a portion of a semiconductor switch device, comprising a multitude of switches.

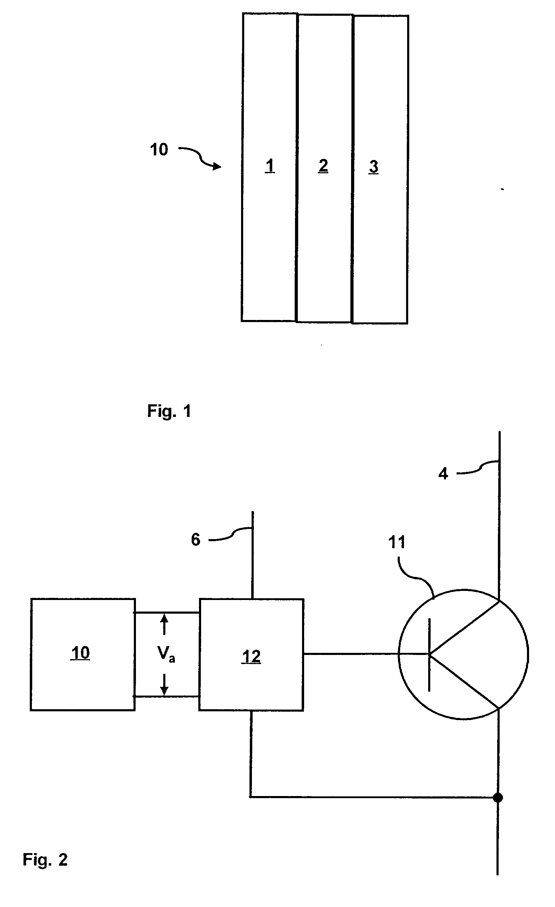

Fig. 1 shows an example embodiment of an auxiliary power supply device 10 for a semiconductor switch device 11. The auxiliary power supply 10 comprises at least one TEG 2. Preferably, the auxiliary power supply 10 is applied to at least one heat generator 3. Said TEG 2 and said heat generator 3 are joint, preferably by at least one interface. Preferably, the auxiliary power supply 10 is applied to at least one heat sink 1. Said TEG 2 and said heat sink 1 are joint, preferably by at least one interface.

### Description of preferred Embodiments of the Invention

According to a preferred embodiment of a TEG 2, the TEG 2 consists of a multitude of thermocouples made from bismuth telluride based alloys. When applied to a heat difference, the TEG 2 converts thermal energy that passes through it into electricity.

The TEG 2 requires e.g. a heat flux of e.g. 8 W/cm². With a temperature difference of e.g. 200°C, the TEG 2 converts e.g. 5% of the thermal energy, generating a minimum of e.g. 14 W of electric power. When properly installed it will run for tens of thousands of hours. Such a TEG is well known to the man skilled in the art.

Optionally, a compression device is provided. It may comprise clamping means to assure consistent orthogonal force. Putting the heat generator 3, the TEG 2 and the heat sink 1 under a compressive load maintains a constant compression and maximizes heat transfer across the interfaces. Experimentation shows that most of the beneficial effects on heat transfer are achieved with e.g. 8 atm compressive load. In determining the compressive load it is important to accommodate also the thermal expansion of a TEG 2, which is e.g. 20x10⁻⁶°C⁻¹. Such a compression device of a TEG respectively such a semiconductor switch device is well known to the man skilled in the art.

Fig. 2 is a block diagram of an auxiliary power supply device 10 for a semiconductor switch device 11. In this example embodiment, the semiconductor switch device 11 is part of an GTO thyristor, or a MCT, or a MTO, or an IGT, or an IGCT, or a MOSFET, or an IGBT, etc.. Preferably, the semiconductor switch device 11 comprises a gate drive and protection device 12 and an auxiliary power supply device 10. A main voltage is applied in at least one electric conductor 4. The main voltage may have several kV of electric voltage. Outputs of the auxiliary power supply device 10 deliver at least one auxiliary voltage Vₐ of e.g. +/-3 to +/-20V. The auxiliary power supply device 10 may deliver several auxiliary voltages Vₐ, such as a first auxiliary voltage Vₐ of +5V, respectively a second auxiliary voltage Vₐ of +20V, respectively a third auxiliary voltage Vₐ of -10V. Preferably, an auxiliary voltage Vₐ is delivered to a power supply voltage input of the gate drive and protection device 12. The gate drive and protection device 12 is commanded by means of at least one gate signal. For example, the gate signal turns the semiconductor switch device 11 on or off. Preferably, the gate signal is transmitted via a gate signal line 6 to a gate signal input of the gate drive and protection device 12, which may be a fibre optic cable respectively a coaxial cable, etc.. Preferably, a gate signal output of the gate drive and protection device 12 is connected to a gate of the semiconductor switch device 11. Such an auxiliary power supply device respectively such a gate drive and protection device respectively such a gate signal line is well known to the man skilled in the art.

The TEG 2 is embedded in a thermo-management of the semiconductor switch device 11. Thermo-management means, that the temperature gradient of the TEG 2 is produced actively and/or passively. Preferably, the heat generator 3 is at least one electric resistor 30, 30' and/or at least one PTC resistor and/or at least one heat conductor.

Preferably a heat sink 1 is provided which is part of the semiconductor switch device 11. According to a preferred embodiment of a heat sink 1, the heat sink 1 is a connection plate in combination with a compression device 5. The connection plate has high heat conductivity. The heat sink may be water- respectively air-cooled. Such a heat sink of a semiconductor switch device 11 is well known to the man skilled in the art.

Preferably, a heat conductor conducts waste energy of the semiconductor switch device 11 to the TEG 2. In a passive thermo-management, the heat conductor is preferably mechanically connected to hot regions of the semiconductor switch device 11, where heat is generated. Preferably, the heat conductors are made form thermically good conductors such as copper, silver, gold, etc.. Such a heat conductor is well known to the man skilled in the art.

The invention is particularly suitable for HVDC applications, where an auxiliary power supply 10 based an at least one TEG 2 provides an auxiliary voltage Vₐ to a semiconductor switch device 11, which may be high voltage converter, such as a three phase converter, etc..

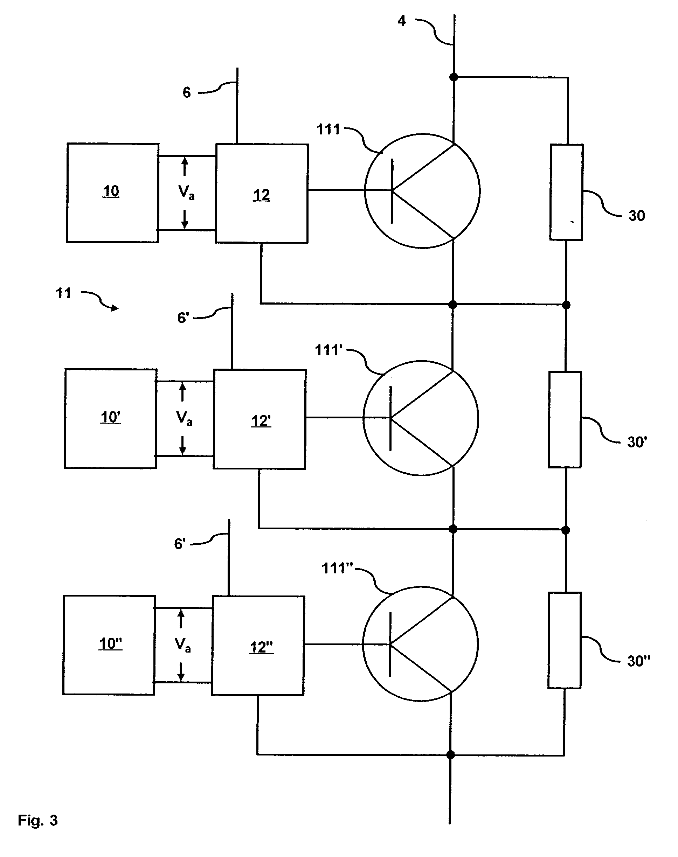

Fig. 3 shows an example embodiment of a semiconductor switch device 11 of a HVDC application comprising a multitude of switches 111, 111', 111". The semiconductor switch device 11 switches an electric voltage or main voltage. Said main voltage is applied in at least one electric conductor 4. The height of said electric voltage often exceeds the electric insulation of the switches 111, 111', 111". The main voltage may be HVDC higher than 30 kV DC, preferably higher than 60kV DC, preferably higher than 90kv DC, preferably higher than 110kV DC. Toady's switches 111, 111', 111" are, however, limited to insulation voltages of several thousands V only. As a result, the semiconductor switch device 11 comprises at least one electric insulation stage. Preferably the semiconductor switch device 11 comprises a multitude of electric insulation stages, resulting in a multitude of switches 111, 111', 111" being connected in series.

Fig. 3 shows an example embodiment of a semiconductor switch device 11 comprising three switches 111, 111', 111" being connected in series. Preferably, each switch 111, 111', 111" is provided with a gate drive and protection device 12, 12', 12" and an auxiliary power supply device 10, 10', 10". Each auxiliary power supply device 10, 10', 10"comprises a TEG. Preferably, each a TEG is applied to a heat sink of a switch 111, 111', 111". For more details concerning the gate drive and protection devices 12, 12', 12" and an auxiliary power supply devices 10, 10', 10", reference is made to the description of Fig. 1 and 2.

Due to the different leakage current of these switches 111, 111', 111", electric resistors 30, 30', 30" are used for static voltage balancing. Preferably, each switch 111, 111', 111" is connected in parallel with an electric resistor 30, 30', 30", said resistor being e.g. a voltage balancing resistor network and/ or a clemp resistor and/or a snubber resistor. Said electric resistors 30, 30', 30" generate waste heat. Preferably, said waste heat may be used in an active thermo-management as heat generator 3 for the aim of the present invention.

The TEG 2 and the semiconductor switch device 11 may be packaged together as a module. Due to the relatively compact size of the TEG 2 and due to the fact that often the same semiconductor materials are used in the TEG 2 and in the semiconductor switch device 11, such a packaging offers great advantages in the production of semiconductor switch devices.

According to a preferred embodiment of a PTC resistor, a PTC resistor is a doped polycrystalline ceramic stone (based on barium titanate) with an electric resistance. When applied to an electric current, the PTC resistor heats to a predetermined plateau temperature, then plateau, because the ceramic stone's resistance increases with temperature. The doped polycrystalline ceramics utilize the semiconducting and ferro-electrical properties of the ceramic to produce self-limiting effects, holding the temperature at a constant level. In an active thermo-management, a PTC resistor is used as heat generator 3 for the aim of the present invention. Such a PTC resistor is well known to the man skilled in the art.

Modifications within the spirit of the invention will be apparent to those skilled in the art. For example, any other heat generator instead of an electric resistor and/or a PTC resistor and/or a heat conductor may be used. The electric resistor may be incorporated in the main voltage and/or connected to an electric storage battery. The heat sink may be omitted, if a sufficiently high temperature gradient is available for running the TEG from a heat generator alone. Further improvement of the system performance can be achieved by combining the heat produced by an electric resistor and a PTC resistor, respectively by an electric resistor and a heat conductor, respectively by a PTC resistor and a heat conductor. For example, it may be sufficient, to use solely waste energy of the semiconductor switch device by means of an electric resistor and/or a heat conductor to result in a temperature gradient at the TEG for producing an auxiliary voltage.

### List of reference signs

- 1: heat sink
- 2: thermoelectric generator
- 3: heat generator
- 4: electric conductor
- 6, 6', 6": gate signal line
- 10, 10', 10": auxiliary power supply device
- 11: semiconductor switch device
- 12, 12', 12": gate drive and protection device
- 30, 30', 30": electric resistor
- 111, 111',111": switch
- Vₐ: auxiliary voltage

## Claims

1. An auxiliary power supply device (10) for a semiconductor switch device (11), wherein at least one thermoelectric generator (2) is supplying an auxiliary voltage (Vₐ).

2. Auxiliary power supply device (10) according to claim 1, wherein at least one heat generator (3) and/or at least one heat sink (1) is/are provided.

3. Auxiliary power supply device (10) according to claim 2, wherein said heat generator (3) and said thermoelectric generator (2) are joint by at least one interface and/or said thermoelectric generator (2) and said heat sink (1) are joint by at least one interface.

4. Auxiliary power supply device (10) according to claim 2 or 3, wherein said heat generator (3) is at least one electric resistor (30, 30', 30"), preferably a voltage balancing resistor network and/ or a clemp resistor and/ or a snubber resistor, and/or at least one positive temperature coefficient resistor and/or at least one heat conductor.

5. Auxiliary power supply device (10) according to claim 4, wherein said positive temperature coefficient resistor starts up the auxiliary power supply device (10) automatically.

6. Module, comprising an auxiliary power supply device (10) and a semiconductor switch device (11), wherein at least one thermoelectric generator (2) is supplying an auxiliary voltage (Vₐ).

7. Module, according to claim 6, wherein said thermoelectric generator (2) is packaged with the semiconductor switch device (11).

8. Semiconductor switch device (11), comprising at least one switch (111, 111', 111") and an auxiliary power supply device (10) for said switch (111, 111', 111"), wherein at least one thermoelectric generator (2) is supplying an auxiliary voltage (Vₐ).

9. Semiconductor switch device (11) according to claim 8, wherein the thermoelectric generator (2) is applied to a heat sink of a switch (111, 111', 111") and/or wherein the thermoelectric generator (2) is applied to a heat generator of said switch (111, 111', 111").

10. Method for supplying auxiliary power to a semiconductor switch device (11), comprising the step of providing at least one thermoelectric generator (2) supplying an auxiliary voltage (Vₐ).

11. Method according to claim 10, wherein at least one heat generator (3) and/or a heat sink (1) of the semiconductor switch device (11) produce a sufficiently high temperature gradient for running the thermoelectric generator (2).

12. Method according to claim 11, wherein a heat generator (3) being at least one electric resistor (30, 30', 30"), preferably a voltage balancing resistor network and/or a clemp resistor and/ or a snubber resistor, and/or at least one positive temperature coefficient resistor and/or at least one heat conductor is/are used for producing heat for running the thermoelectric generator (2).
